# EUROPÄISCHE PATENTANMELDUNG

(11) **EP 3 483 992 A1**
(43) Veröffentlichungstag der Anmeldung: **15.05.2019**
(21) Anmeldenummer: 18206268.7
(22) Anmeldetag: 14.11.2018
(51) Int. Cl.: H01S 5/00, H01S 5/42, G03B 21/20, H04N 9/31, G01B 11/25

(54) **PROJEKTIONSVORRICHTUNG ZUM PROJIZIEREN EINES OPTISCHEN MUSTERS AUF EIN OBJEKT**

(30) Priorität: 14.11.2017 DE 102017010520
(71) Anmelder: Z-Laser Optoelektronik GmbH, 79100 Freiburg Baden-Württemberg (DE)
(72) Erfinder: Erhardt, Christian, 79106 Freiburg Baden-Württemberg (DE)
(74) Vertreter: Huwer, Andreas

(57) **Zusammenfassung**

Eine Projektionsvorrichtung (1) zum Projizieren eines optischen Musters auf ein Objekt hat einen oberflächenemittierenden Vertikal-Kavitätslaser (2), der ein Halbleitersubstrat (3) aufweist, auf dem eine Mehrzahl von Oberflächenemittern (4) angeordnet sind, die zur Bildung einer zweidimensionalen Laseranordnung in quer zueinander verlaufenden Richtungen zueinander versetzt sind. In den Strahlengängen der von den Oberflächenemittern (4) ausgesandten Laserstrahlen (7) ist eine Kollimationsoptik (13) angeordnet, mittels der die von den einzelnen Oberflächenemittern (4) ausgesandten Laserstrahlen (7) jeweils zu einem Kollimationsstrahl (14) kollimierbar sind. Die Oberflächenemitter (4) sind in einem regelmäßigen zweidimensionalen Raster angeordnet. Zwischen dem Halbleitersubstrat (3) und der Kollimationsoptik (13) ist eine Ablenkoptik (8) angeordnet ist, mittels der die von den einzelnen Oberflächenemittern (4) ausgesandten Laserstrahlen (7) unterschiedlich ablenkbar sind. Die abgelenkten Laserstrahlen (7) treffen auf die Kollimationsoptik (13) auf.

## Beschreibung

Die Erfindung betrifft eine Projektionsvorrichtung zum Projizieren eines optischen Musters auf ein Objekt, mit einem oberflächenemittierenden Vertikal-Kavitätslaser (VCSEL), der ein Halbleitersubstrat aufweist, auf dem eine Mehrzahl von Oberflächenemittern angeordnet sind, die zur Bildung einer zweidimensionalen Laseranordnung in quer zueinander verlaufenden Richtungen zueinander versetzt sind, mit einer in den Strahlengängen der von den Oberflächenemittern ausgesandten Laserstrahlen angeordneten Kollimationsoptik, mittels der die von den einzelnen Oberflächenemittern ausgesandten Laserstrahlen jeweils zu einem Kollimationsstrahl kollimierbar sind.

Eine derartige Projektionsvorrichtung ist aus US 8 749 796 B2 bekannt. Sie hat einen oberflächenemittierenden Vertikal-Kavitätslaser (VCSEL), der ein Halbleitersubstrat aufweist, auf dem eine Vielzahl von Oberflächenemittern in einem nicht regelmäßigen, zweidimensionalen Raster angeordnet sind. Dabei wird unter einem nicht regelmäßigen Raster ein Raster verstanden, bei dem die Oberflächenemitter nicht in einem periodischen Gitter angeordnet und insbesondere zufällig oder pseudozufällig verteilt sind. Die Oberflächenemitter sind so in das Halbleitersubstrat integriert, dass die Laserstrahlung an einer parallel zu der von dem Halbleitersubstrat aufgespannten Ebene angeordneten Oberfläche des Halbleitersubstrats austritt.

Die vorbekannte Projektionsvorrichtung weist ferner eine Kollimationsoptik auf, die als plankonvexe optische Linse ausgestaltet ist, welche von den Strahlengängen der von den Oberflächenemittern ausgesandten Laserstrahlen durchsetzt wird. Mit Hilfe der Kollimationsoptik werden die einzelnen Laserstrahlen fokussiert, um ein Strahlenbündel zu erzeugen, dessen Projektion ein optisches Muster aufweist, welches der nicht regelmäßigen Anordnung der Oberflächenemitter auf dem Halbleitersubstrat entspricht.

In Lichtabstrahlrichtung hinter der Kollimationsoptik ist ein optischer Vervielfacher angeordnet, der dazu dient, aus dem durch die Kollimationsstrahlen gebildeten Strahlenbündel eine Vielzahl von nebeneinander angeordneten Strahlenbündeln zu erzeugen, die hinsichtlich der Anordnung, die ihre jeweiligen Kollimationsstrahlen relativ zueinander aufweisen, übereinstimmen. Dadurch wird das durch die aus der Kollimationsoptik austretende Strahlenbündel gebildete optische Muster vervielfältigt und es wird ein größeres Strahlenbündel, mit dem eine Vielzahl der der regelmäßigen Anordnung der Oberflächenemitter auf dem Halbleitersubstrat entsprechenden optischen Muster nebeneinander projiziert werden können.

Die vorbekannte Projektionsvorrichtung kann dazu verwendet werden, ein strukturiertes optisches Muster in Form einer Punktewolke auf ein Objekt zu projizieren, um die Geometrie des Objekts mit Hilfe von Methoden der Bildverarbeitung berührungslos dreidimensional zu vermessen. Bei der Messung werden für Stellen, an denen optische Punkte auf das Objekt projiziert werden, dreidimensionale Geometriedaten erzeugt und abgespeichert.

Die vorbekannte Projektionsvorrichtung hat jedoch den Nachteil, dass der oberflächenemittierende Vertikal-Kavitätslaser, bei denen die Oberflächenemitter in einem anwendungsspezifischen, nicht regelmäßigen, zweidimensionalen Raster angeordnet sind, relativ teuer ist. Da Vertikal-Kavitätslaser nur in relativ großer Stückzahl kostengünstig hergestellt werden können, ist der Einsatz solcher Vertikal-Kavitätslasern bei Kleinserien aus wirtschaftlichen Gründen problematisch.

Es ist auch bereits bekannt, in Projektionsvorrichtungen zum Projizieren eines optischen Musters auf ein Objekt Einzellaser zum Erzeugen der Laserstrahlen zu verwenden. Bei den Einzellasern ist der optische Resonator so in einen Halbleiterchip integriert, dass die Laserstrahlung an einer Stirn- bzw. Schmalseite aus dem Halbleiterchip austritt. Bei der Herstellung der Einzellaser werden zunächst Strukturen für eine Vielzahl von Einzellasern in einen Halbleiterwafer integriert. Danach wird der Wafer zerteilt und die Kanten bzw. Schmalseiten, an denen die Laserstrahlung aus den Halbleiterchips austreten soll, werden poliert. Da das Polieren zeitaufwändig ist, ist die Herstellung der Einzellaser entsprechend teuer.

Es besteht deshalb die Aufgabe, eine Projektionsvorrichtung der eingangs genannten Art zu schaffen, die auch in Kleinserie oder in geringen Stückzahlen kostengünstig herstellbar ist. Außerdem soll es die Projektionsvorrichtung ermöglichen, einen relativ großen Anteil des von den Oberflächenemittern ausgesandten Laserlichts zum Projizieren des optischen Musters nutzbar zu machen, d.h. das optische Muster soll energiesparend erzeugt werden.

Erfindungsgemäß wird vorstehend genannten Aufgabe bei einer Projektionsvorrichtung der eingangs genannten Art dadurch gelöst, dass die Oberflächenemitter in einem regelmäßigen zweidimensionalen Raster angeordnet sind, und dass zwischen dem Halbleitersubstrat und der Kollimationsoptik eine Ablenkoptik angeordnet ist, mittels der die von den einzelnen Oberflächenemittern ausgesandten Laserstrahlen unterschiedlich ablenkbar sind, derart, dass die abgelenkten Laserstrahlen auf die Kollimationsoptik auftreffen.

In vorteilhafter Weise ist es dadurch möglich, für die Projektionsvorrichtung einen oberflächenemittierenden Vertikal-Kavitätslaser (VCSEL) zu verwenden, bei dem die die Oberflächenemitter in einem regelmäßigen zweidimensionalen Raster angeordnet sind. Dabei wird unter einem regelmäßigen zweidimensionalen Raster ein Raster verstanden, bei dem die Oberflächenemitter in einem periodischen Gitter angeordnet sind. Da derartige Vertikal-Kavitätslaser für eine Vielzahl von unterschiedlichen Anwendungen in großen Stückzahlen benötigt werden, sind sie entsprechend kostengünstig herstellbar. Mit Hilfe der erfindungsgemäßen Ablenkoptik ist es möglich, die einzelnen, von den im regelmäßigen Raster angeordneten Oberflächenemittern ausgesandten Laserstrahlen, derart unterschiedlich abzulenken, dass die geraden Verlängerungen der abgelenkten Laserstrahlen die Ebene des Halbeiterchips, von der die Laserstrahlen ausgesandt werden, virtuelle Punktlichtquellen schneiden, die in einem nicht regelmäßigen zweidimensionalen Raster angeordnet sind. Die von der Ablenkoptik in Richtung der Kollimationsoptik abgestrahlten, abgelenkten Lichtstrahlen entsprechen also den Lichtstrahlen, die von einem oberflächenemittierenden Vertikal-Kavitätslasers ausgesandt werden, der an den Stellen, an denen die virtuellen Lichtquellen angeordnet sind, Oberflächenemitter aufweist. Der Kollimationsstrahl kann ein konvergierender Kollimationsstrahl sein.

Bei einer bevorzugten Ausgestaltung der Erfindung ist vorgesehen, dass der Abstand zwischen der Ablenkoptik und dem Halbleitersubstrat derart gering ist, dass die von den Oberflächenemittern ausgesandten Laserstrahlen in einem Bereich, in dem ihre Strahlintensität jeweils mehr als 25%, insbesondere mehr als 20%, gegebenenfalls mehr als 16% und bevorzugt mehr als 13,5 % ihrer betreffenden Maximalintensität beträgt, sich zwischen dem Halbleitersubstrat und der Ablenkoptik nicht überschneiden. Die Ablenkoptik kann dann für jeden abzulenkenden Laserstrahl ein entsprechendes optisches Ablenkelement oder einen entsprechenden Ablenkbereich aufweisen, das bzw. der im Wesentlichen nur den betreffenden Laserstrahl ablenkt. Wenn die Kollimationsstrahlen auf eine ebene Oberfläche projiziert werden, ergibt sich dann ein optisches Muster, bei dem sich die einzelnen Bildpunkte des optischen Musters gut voneinander trennen und einem Oberflächenemitter zuordnen lassen.

Bei einer zweckmäßigen Ausführungsform der Erfindung ist die Ablenkoptik derart ausgestaltet, dass sie die Laserstrahlen von mindestens zwei Oberflächenemittern in unterschiedliche Richtungen ablenkt. Dabei ist es insbesondere möglich, dass die Ablenkoptik einen Laserstrahl in eine erste Richtung und einen weiteren Laserstrahl in eine zur ersten Richtung entgegengesetzte zweite Richtung ablenkt. Außerdem kann die Ablenkoptik so ausgestaltet sein, dass sie einen Laserstrahl in eine erste Richtung und einen zweiten Laserstrahl in eine zur ersten Richtung orthogonale zweite Richtung ablenkt.

Bei einer bevorzugten Ausgestaltung der Erfindung ist die Ablenkoptik derart ausgestaltet, dass bei den Laserstrahlen von mindestens zwei Oberflächenemittern der Ablenkwinkel zwischen dem von dem betreffenden Oberflächenemitter auf die Ablenkoptik auftreffenden Laserstrahl und dem an der Ablenkoptik in Richtung auf Kollimationsoptik abgelenkten Laserstrahl unterschiedlich groß ist. Die Ablenkoptik kann zu diesem Zweck für die einzelnen Laserstrahlen jeweils ein Mikroprisma aufweisen, mit einer reflektierenden oder lichtbrechenden optisch wirksamen Oberfläche, die relativ zu dem abzulenkenden Laserstrahl geneigt ist.

Bei einer vorteilhaften Ausführungsform der Erfindung ist die Ablenkoptik derart ausgestaltet, dass bei Projektion der Kollimationsstrahlen auf eine normal zur optischen Achse der Kollimationsoptik angeordnete ebene Projektionsfläche, auf der Projektionsfläche ein selbstunähnliches optisches Muster abgebildet wird. Unter dem Begriff "selbstunähnlich" wird verstanden, dass in dem projizierten Muster keine durch mehr als einen Kollimationsstrahl projizierten Untermuster enthalten sind, die sich innerhalb des Musters wiederholen. Die Ablenkung der von den Oberflächenemittern ausgesandten Laserstrahlen kann so erfolgen, dass sämtliche Laserstrahlen, die in die Kollimationsoptik eintreten bzw. auf diese auftreffen, in unterschiedliche Richtungen weisen.

Bei einer Weiterbildung der Erfindung weist die Projektionsvorrichtung einen in den Strahlengängen der Kollimationsstrahlen angeordneten optischen Vervielfacher auf, der dazu geeignet ist, aus dem durch die Kollimationsstrahlen gebildeten Strahlenbündel mindestens zwei Strahlenbündel zu erzeugen, die in vorzugsweise unterschiedliche Richtungen weisen und hinsichtlich der Anordnung, die ihre Kollimationsstrahlen relativ zueinander aufweisen, übereinstimmen. Hierdurch kann das mit der Projektionsvorrichtung projizierbare optische Muster erweitert bzw. vergrößert werden, indem mehrere im Wesentlichen identische optische Muster nebeneinander auf eine Projektionsfläche projiziert werden. Der optische Vervielfacher kann mindestens ein Prisma aufweisen, mit dem die Kollimationsstrahlen geteilt und ggf. in unterschiedliche Richtungen abgelenkt werden können. Zum Vervielfältigen des Strahlenbündels kann der Vervielfacher auch einen teildurchlässigen Spiegel aufweisen.

Bei einer bevorzugten Ausgestaltung der Erfindung ist (sind) die Ablenkoptik und/oder der optische Vervielfacher als diffraktives optisches Element ausgestaltet. Dies ermöglicht kompakte Abmessungen und eine kostengünstige Herstellung der Ablenkoptik bzw. des Vervielfachers.

Bevorzugt entspricht die Intensitätsverteilung der einzelnen Laserstrahlen über den Strahlquerschnitt jeweils im Wesentlichen einer Gaußverteilung. Dies ermöglicht eine Projektion einer optischen Punktewolke auf ein Objekt, bei der die einzelnen Punkte konturenscharf wiedergegeben werden und geringe Querschnittsabmessungen aufweisen.

Nachfolgend ist ein Ausführungsbeispiel der Erfindung anhand der Zeichnung näher erläutert. Es zeigt zum Teil stärker schematisiert:
- Fig. 1: einen schematischen Längsschnitt durch eine Projektionsvorrichtung zum Projizieren eines strukturierten optischen Musters auf ein Objekt, bei dem die Hauptachsen der Strahlengänge von Laserstrahlen durch strichlinierte Linien dargestellt sind,
- Fig. 2: eine Aufsicht auf die Emissionsseite eines oberflächenemittierenden Vertikal-Kavitätslasers (VCSEL), wobei die Oberflächenemitter des VCSEL strichlinierte Kreise und virtuelle Emissionsstellen durch durchgehende Kreislinien markiert sind,

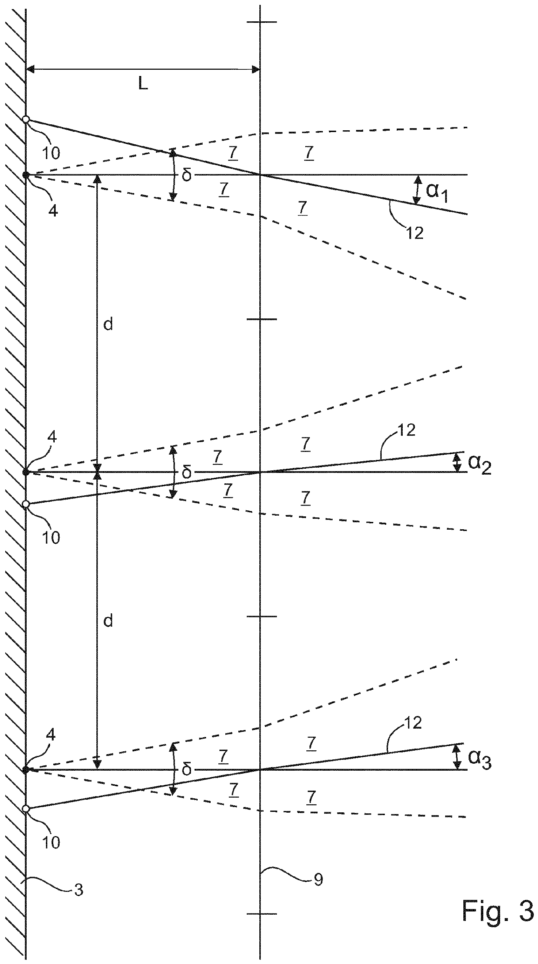

- Fig. 3: einen graphische Darstellung der Strahlengänge von Laserstrahlen, die von drei Oberflächenemittern des VCSEL emittiert werden, wobei das Halbleitersubstrat des VCSEL im Querschnitt dargestellt ist und die Zeichenebene normal zu der vom Halbleitersubstrat aufgespannten Chipebene angeordnet ist,
- Fig. 4: eine schematische Darstellung, welche die Ablenkrichtung und den Ablenkwinkel einer Ablenkoptik für die von den einzelnen Oberflächenemittern eines VCSEL emittierten Laserstrahlen verdeutlicht.

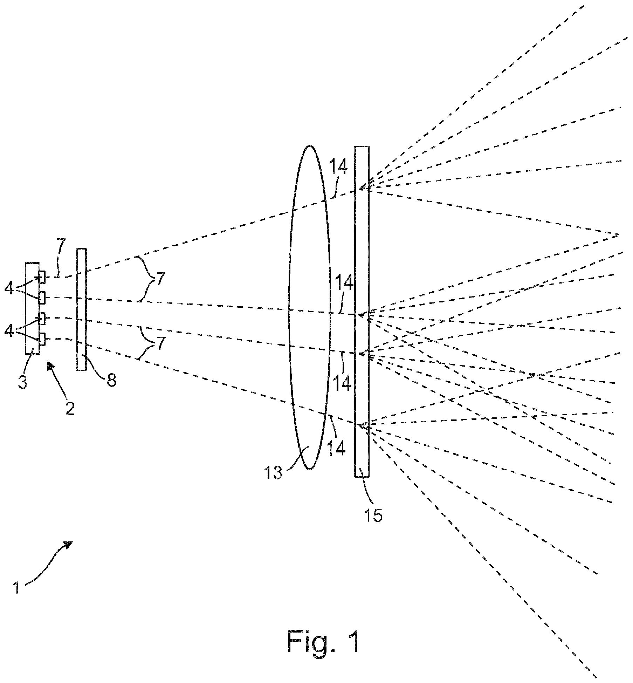

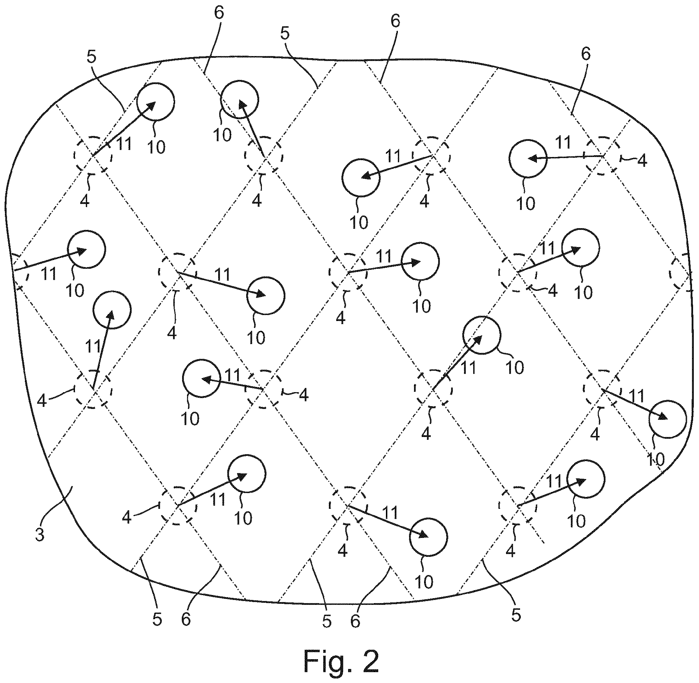

Eine in Fig. 1 im Ganzen mit 1 bezeichnete Projektionsvorrichtung zum Projizieren eines strukturierten optischen Musters auf ein Objekt hat einen oberflächenemittierenden Vertikal-Kavitätslaser 2 (VCSEL), der ein Halbleitersubstrat 3 aufweist, in das eine Vielzahl von Oberflächenemittern 4 integriert sind, die in Fig. 2 schematisch durch strichlinierte Kreise dargestellt sind. Die Abstrahlcharakteristik der von den einzelnen Oberflächenemittern 4 jeweils ausgesandten Laserstrahlung entspricht der eines TEMoo-Modes.

Wie in Fig. 2 zu sehen ist, sind die Oberflächenemitter 4 in einem gedachten, regelmäßigen, zweidimensionalen Raster angeordnet. Dieses hat gedachte erste und zweite Rasterlinien 5, 6. Die ersten Rasterlinien 5 verlaufen in konstanten Abständen parallel zueinander und parallel zu der vom Halbleitersubstrat 3 aufgespannten Chipebene. Die zweiten Rasterlinien 6 verlaufen ebenfalls in konstanten Abständen parallel zueinander und parallel zur Chipebene. Die zweiten Rasterlinien 6 sind quer zu den ersten Rasterlinien 5 angeordnet und schneiden diese an Kreuzungsstellen, an denen die Oberflächenemitter 4 angeordnet sind.

Auf den einzelnen ersten Rasterlinien 5 sind jeweils mehrere Oberflächenemitter 4 in konstanten Rasterabständen d versetzt zueinander angeordnet. In entsprechender Weise sind jeweils auf den zweiten Rasterlinien 6 mehrere Oberflächenemitter 4 im Rasterabstand d zueinander versetzt. Die Oberflächenemitter 4 sind also an Kreuzungsstellen rautenförmiger gedachter Gitterlinien auf dem Halbleitersubstrat 3 angeordnet. Es sind aber auch andere regelmäßige, zweidimensionale Anordnungen der Oberflächenemitter 4 denkbar. Insbesondere können die Oberflächenemitter 4 in einem hexagonalen Gitter angeordnet sein.

Die einzelnen Oberflächenemitter 4 emittieren jeweils einen Laserstrahl 7, der mit seiner Hauptabstrahlrichtung etwa orthogonal zur Chipebene des Halbleitersubstrats 3 ausgerichtet ist. Die Strahlengänge der Laserstrahlen sind in Fig. 1 schematisch durch strichlinierte Linien dargestellt.

Wie in Fig. 1 erkennbar ist, weist die Projektionsvorrichtung 1 eine Ablenkoptik 8 auf, die mit ihrer optisch wirksamen Ebene 9 derart in einem Abstand L von den Emissionsstellen der Oberflächenemitter 4 angeordnet ist, dass die Laserstrahlen 7 die Ablenkoptik 8 durchsetzen. Der Abstand L zwischen der optisch wirksamen Ebene 9 der Ablenkoptik 8 und der Oberfläche des Halbleitersubstrats 3, von der aus die Laserstrahlen 7 emittiert werden, sowie der Öffnungswinkel δ, unter dem die Laserstrahlung jeweils von den einzelnen Oberflächenemittern 4 zur Ablenkoptik 8 hin ausgesendet wird (Divergenz), sind so aufeinander abgestimmt, dass die Flächen, welche die einzelnen Laserstrahlen 7 in der optisch wirksamen Ebene 9 der Ablenkoptik 8 mit einer Intensität bestrahlen, die größer als 1/e² (ca. 13,5 %) der Maximalintensität der Laserstrahlen 7 ist, voneinander beabstandet sind. Die Laserstrahlen 7 durchdringen sich also auf ihrem Weg von den Oberflächenemittern 4 zur optisch wirksamen Ebene 9 der Ablenkoptik 8 hin nicht.

Die Ablenkoptik 8 ist als diffraktives optisches Element ausgestaltet, das für jeden Laserstrahl 7 jeweils einen optisch wirksamen Bereich aufweist, an dem der betreffende Laserstrahl 7 beim Durchtritt durch die Ablenkoptik 8 abgelenkt wird. Die Ablenkung ist bei allen Laserstrahlen 7, die von dem oberflächenemittierenden Vertikal-Kavitätslaser 2 ausgesandt werden, unterschiedlich. Dabei wird unter "unterschiedlich" verstanden, dass die Laserstrahlen 7 in unterschiedliche Richtungen und/oder unter unterschiedlichen Ablenkwinkeln α₁, α₂, α₃ in Bezug zu ihrer Einfallsrichtung abgelenkt werden.

Die Ablenkung bewirkt, dass der Laserstrahl 7 für einen Betrachter, der durch die Ablenkoptik 8 hindurch senkrecht auf die Oberfläche des Halbleitersubstrats 3 schaut, scheinbar von einem virtuellen Oberflächenemitter 10 abgestrahlt wird, der gegenüber dem physikalischen Oberflächenemitter 4, aus dem der Laserstrahl 7 tatsächlich austritt, seitlich versetzt ist. In Fig. 2 ist dieser Versatz bei den einzelnen Oberflächenemittern 10 durch Pfeile 11 dargestellt.

Die virtuellen Oberflächenemitter 10 sind jeweils im Schnittpunkt der geraden Verlängerung der optischen Achse 12 des betreffenden abgelenkten Laserstrahls 7 mit der Ebene angeordnet, in der sich die Emissionsstellen der Oberflächenemitter 4 befinden.

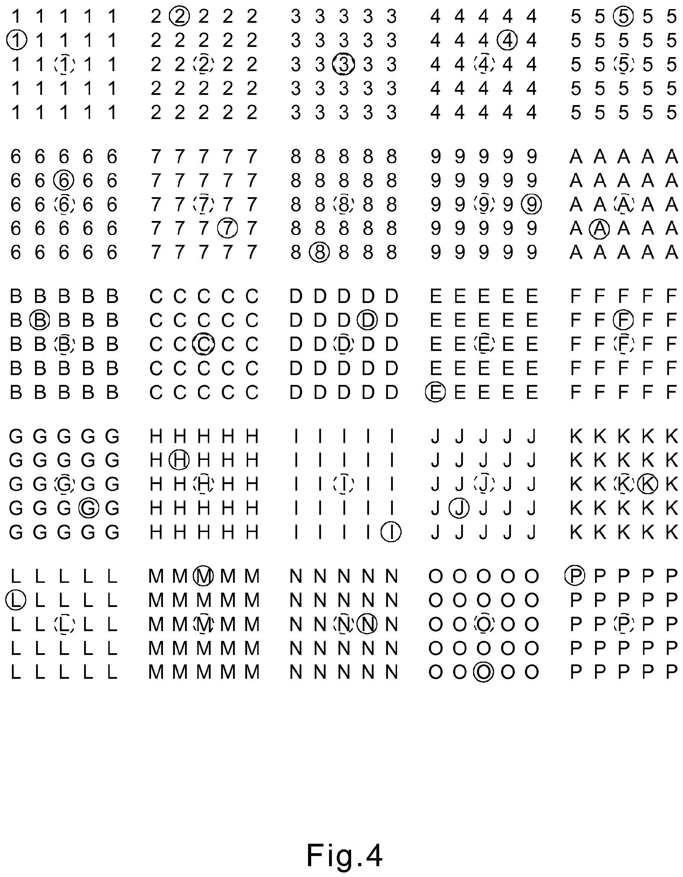

In Fig. 4 ist für einen oberflächenemittierenden Vertikal-Kavitätslaser 2 mit 5 x 5 matrixförmig angeordneten Oberflächenemittern 4 schematisch dargestellt, wie die Laserstrahlen 7, die von den einzelnen Oberflächenemittern 4 emittiert werden, jeweils mit Hilfe der Ablenkoptik 8 abgelenkt werden. Für jeden Oberflächenemitter 4 enthält die Fig. 4 jeweils ein quadratisches Feld mit einer der Anzahl der Oberflächenemitter 4 übereinstimmenden Anzahl von Positionen. Die Anordnung der Felder entspricht der Anordnung der Oberflächenemitter 4. Die Positionen der einzelnen Felder sind jeweils mit gleichen Pentavigesimalzahlen "1 ", "2", ..., "O", "P" beschriftet, welche den betreffenden Oberflächenemitter 4 bezeichnen.

Der physikalische Oberflächenemitter 4 befindet sich jeweils in der Mitte des betreffenden Felds und ist durch einen strichlinierten Kreis dargestellt. Die durch die Ablenkoptik 8 verursachte Ablenkung des von dem betreffenden Oberflächenemitter 4 ausgesandten Laserstrahls 7 bewirkt, dass der Laserstrahl 7 für einen Betrachter, der durch die Ablenkoptik 8 hindurch senkrecht auf die Oberfläche des Halbleitersubstrats 3 schaut, scheinbar von einem virtuellen Oberflächenemitter 10 abgestrahlt wird, der gegenüber dem physikalischen Oberflächenemitter 4 seitlich versetzt ist. Die virtuellen Oberflächenemitter 10 sind in Fig. 4 durch durchgezogene Kreislinien markiert.

Die Ablenkung der von den einzelnen Oberflächenemittern 4 ausgesandten Laserstrahlen 7 wird bei der Dimensionierung der Ablenkoptik 8 mit Hilfe eines an sich bekannten Markov-Algorithmus ermittelt. Dieser sorgt dafür, dass sich die Verteilung der virtuellen Oberflächenemitter 10 nicht wiederholt und somit quasi eine Zufallsverteilung erzeugt wird.

Wie in Fig. 1 erkennbar ist, weist die Projektionsvorrichtung 1 außerdem eine Kollimationsoptik 13 auf, mittels der die von den einzelnen Oberflächenemittern 4 ausgesandten Laserstrahlen 7 nach ihrem Durchtritt durch die Ablenkoptik 8 zu konvergierenden Kollimationsstrahlen 14 gebündelt werden. Die Ablenkoptik 8 ist zwischen der Kollimationsoptik 13 und dem Halbleitersubstrat 3 angeordnet. In den Kollimationsstrahlen 14 sind die Laserstrahlen in etwa parallel ausgerichtet oder laufen etwas aufeinander zu.

In Ausbreitungsrichtung der Laserstrahlen 7 hinter der Kollimationsoptik 13 ist ein optischer Vervielfacher 15 angeordnet, mittels dem aus dem durch die Kollimationsstrahlen 14 gebildeten Strahlenbündel eine Vielzahl von Strahlenbündeln erzeugt werden, um das mit Hilfe der Projektionsvorrichtung auf das Objekt projizierbare optische Muster zu erweitern. Der Vervielfacher 15 weist ein diffraktives optisches Element auf. Die Kollimationsoptik 13 ist zwischen dem Vervielfacher 15 und der Ablenkoptik 8 angeordnet.

## Patentansprüche

1. Projektionsvorrichtung (1) zum Projizieren eines optischen Musters auf ein Objekt, mit einem oberflächenemittierenden Vertikal-Kavitätslaser (2), der ein Halbleitersubstrat (3) aufweist, auf dem eine Mehrzahl von Oberflächenemittern (4) angeordnet sind, die zur Bildung einer zweidimensionalen Laseranordnung in quer zueinander verlaufenden Richtungen zueinander versetzt sind, mit einer in den Strahlengängen der von den Oberflächenemittern (4) ausgesandten Laserstrahlen (7) angeordneten Kollimationsoptik (13), mittels der die von den einzelnen Oberflächenemittern (4) ausgesandten Laserstrahlen (7) jeweils zu einem Kollimationsstrahl (14) kollimierbar sind, **dadurch gekennzeichnet, dass** die Oberflächenemitter (4) in einem regelmäßigen zweidimensionalen Raster angeordnet sind, und dass zwischen dem Halbleitersubstrat (3) und der Kollimationsoptik (13) eine Ablenkoptik (8) angeordnet ist, mittels der die von den einzelnen Oberflächenemittern (4) ausgesandten Laserstrahlen (7) unterschiedlich ablenkbar sind, derart, dass die abgelenkten Laserstrahlen (7) auf die Kollimationsoptik(13) auftreffen.

2. Projektionsvorrichtung (1) nach Anspruch 1, **dadurch gekennzeichnet, dass** der Abstand zwischen der Ablenkoptik (8) und dem Halbleitersubstrat (3) derart gering ist, dass die von den Oberflächenemittern (4) ausgesandten Laserstrahlen (7) in einem Bereich, in dem ihre Strahlintensität jeweils mehr als 25%, insbesondere mehr als 20%, gegebenenfalls mehr als 16% und bevorzugt mehr als 13,5 % ihrer betreffenden Maximalintensität beträgt, sich zwischen dem Halbleitersubstrat (3) und der Ablenkoptik (8) nicht überschneiden.

3. Projektionsvorrichtung (1) nach Anspruch 1 oder 2, **dadurch gekennzeichnet, dass** die Ablenkoptik (8) derart ausgestaltet ist, dass sie die Laserstrahlen (7) von mindestens zwei Oberflächenemittern (4) in unterschiedliche Richtungen ablenkt.

4. Projektionsvorrichtung (1) nach einem der Ansprüche 1 bis 3, **dadurch gekennzeichnet, dass** die Ablenkoptik (8) derart ausgestaltet ist, dass bei den Laserstrahlen (7) von mindestens zwei Oberflächenemittern (4) der Ablenkwinkel zwischen dem von dem betreffenden Oberflächenemitter (4) auf die Ablenkoptik (8) auftreffenden Laserstrahl (7) und dem an der Ablenkoptik (8) in Richtung auf Kollimationsoptik (13) abgelenkten Laserstrahl (7) unterschiedlich groß ist.

5. Projektionsvorrichtung (1) nach einem der Ansprüche 1 bis 4, **dadurch gekennzeichnet, dass** die Ablenkoptik (8) derart ausgestaltet ist, dass bei Projektion der Kollimationsstrahlen (14) auf eine normal zur optischen Achse der Kollimationsoptik (13) angeordnete ebene Projektionsfläche, auf der Projektionsfläche ein selbstunähnliches optisches Muster abgebildet wird.

6. Projektionsvorrichtung (1) nach einem der Ansprüche 1 bis 5, **dadurch gekennzeichnet, dass** die Projektionsvorrichtung (1) einen in den Strahlengängen der Kollimationsstrahlen (14) angeordneten optischen Vervielfacher (15) aufweist, der dazu geeignet ist, aus dem durch die Kollimationsstrahlen (14) gebildeten Strahlenbündel mindestens zwei Strahlenbündel zu erzeugen, die in vorzugsweise unterschiedliche Richtungen weisen und hinsichtlich der Anordnung, die ihre Kollimationsstrahlen (14) relativ zueinander aufweisen, übereinstimmen.

7. Projektionsvorrichtung (1) nach einem der Ansprüche 1 bis 6, **dadurch gekennzeichnet, dass** die Ablenkoptik (8) und/oder der optische Vervielfacher (15) als diffraktives optisches Element ausgestaltet ist.

8. Projektionsvorrichtung (1) nach einem der Ansprüche 1 bis 7, **dadurch gekennzeichnet, dass** die Intensitätsverteilung der einzelnen Laserstrahlen (7) über den Strahlquerschnitt jeweils im Wesentlichen einer Gaußverteilung entspricht.
